**Europäisches Patentamt**

(19) **European Patent Office**

**Office européen des brevets**

(11) Veröffentlichungsnummer: **0 065 589**
**B1**

(12) # EUROPÄISCHE PATENTSCHRIFT

(45) Veröffentlichungstag der Patentschrift:
11.09.85

(51) Int. Cl.⁴: **G 01 R 33/02**

(21) Anmeldenummer: **81104042.7**

(22) Anmeldetag: **26.05.81**

(54) **Verfahren und Anordnung zur Bestimmung eines Magnetfeldes.**

(43) Veröffentlichungstag der Anmeldung:
**01.12.82 Patentblatt 82/48**

(45) Bekanntmachung des Hinweises auf die Patenterteilung:
**11.09.85 Patentblatt 85/37**

(84) Benannte Vertragsstaaten:
**AT BE FR GB IT NL**

(56) Entgegenhaltungen:
**DE - A - 2 414 489**
**DE - A - 2 437 958**
**DE - A - 2 547 254**
**DE - A - 2 823 231**
**DE - B - 1 942 916**
**DE - B - 2 550 060**

(73) Patentinhaber: **Siemens Aktiengesellschaft, Berlin und München Wittelsbacherplatz 2, D-8000 München 2 (DE)**

(72) Erfinder: **Metzner, Uwe, Theodolindenstrasse 49, D-8000 München 90 (DE)**
Erfinder: **Thilo, Peer, Dr.-Ing., Buchhierlstrasse 19, D-8000 München 71 (DE)**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

## Beschreibung

Die Erfindung betrifft ein Verfahren zur Bestimmung eines Magnetfeldes mittels einer Magnetsonde, gemäß dem Oberbegriff des Patentanspruches 1 und eine Anordnung zur Durchführung dieses Verfahrens.

Es soll die Stärke eines Magnetfeldes gemessen bzw. die Richtung eines Magnetfeldes, insbesondere des Erdfeldes, bestimmt werden. Dazu benützt man Magnetsonden, die besonders geeignet sind, das relativ schwache Erdfeld zu messen. Aus der Anordnung zweier Magnetsonden, die in einer horizontalen Ebene senkrecht zueinander stehen, läßt sich je eine Komponente des horizontal einwirkenden Erdfeldes messen. Eine Anordnung mehrerer Magnetsonden, die in einem bestimmten Winkel zueinander stehen, ist aus der DE-OS 2 823 231 bekannt. Dort ist eine sogenannte Tripelsonde zur Messung des Vektors eines örtlichen Magnetfeldes in seiner Richtung und Größe beschrieben. Dabei werden drei Sonden, die in ihren Achsen um 90° gegeneinander versetzt sind, verwendet. Aus dem Vergleich der beiden Feldstärkekomponenten läßt sich mit trigonometrischen Methoden die Magnetfeldrichtung errechnen.

Es ist allgemein bekannt, zur Messung der Magnetfeldstärke folgenden Effekt auszunutzen. Eine Magnetsonde weist einen Eisenkern, eine Primär- und Sekundärwicklung auf. Der durch die Primärwicklung fließende Erregerwechselstrom erzeugt ein inneres Magnetfeld, das sich mit einem äußeren Magnetfeld überlagert. Die in der Sekundärwicklung induzierte Spannung weist aufgrund des äußeren Magnetfeldes asymmetrische Amplituden auf. Die unterschiedlichen Amplituden beider Halbwellen sind ein Maß für die zu messende Feldstärke. Mit geeigneten Auswertevorrichtungen lassen sich die Amplitudendifferenzen ermitteln und zur Anzeige bringen.

Solche Anordnungen haben aber verschiedene Nachteile. Die Nichtlinearität des Eisenkerns führt zu Verzerrungen der induzierten Spannung, so daß die Ausgangsspannung eine signifikant andere Kurvenform als die des treibenden Erregerstroms aufweist. Insbesondere wird eine große Zahl von aussteuerungsabhängigen Oberwellen erzeugt, die sich zu unterschiedlich großen Spitzenspannungen überlagern und so den genauen Vergleich beider Halbwellenamplituden beeinträchtigen. Um diesen Effekt klein zu halten, sind ausgeklügelte, aufwendige Filter und Verstärker erforderlich. Das erzeugte Signal ist eine feldstärkenabhängige Spannung, die im allgemeinen zur weiteren Bearbeitung mit einer zusätzlichen Einrichtung digitalisiert werden muß.

Aus der DE-AS 2 550 060 ist ein Verfahren und eine Einrichtung zur Detektion eines durch Vormagnetisierung eines geschlossenen Magnetkreises erzeugten Magnetfeldes bekannt. Mit der bekannten Einrichtung wird mittels einer Steuereinrichtung eine Gleichspannungsquelle zyklisch umgepolt, um eine Wechselspannung an die Wicklung eines Ringkerns zur Erzeugung einer zyklisch veränderlichen Stromdurchflutung zu legen. Dabei wird eine mit dem Magnetkreis verkettete Stromdurchflutung, die von einem elektrischen Leiter innerhalb des Ringkerns hervorgerufen wird, detektiert. Das heißt, daß ein elektrischer Leiter auf seinen Stromfluß hinsichtlich der Abweichung vom Nullwert oder hinsichtlich der Überschreitung eines Grenzwertes überwacht wird. Eine Bestimmung eines schwachen, äußeren Magnetfeldes, wie des Erdfeldes, bezüglich seiner Stärke bzw. Richtung ist mit dem bekannten Verfahren und der bekannten Einrichtung nicht möglich.

Aufgabe der Erfindung ist es, ein Verfahren und eine Anordnung zur Bestimmung eines äußeren Magnetfeldes anzugeben, das die obengenannten Nachteile vermeidet und das geeignet ist, die Feldstärke und die Feldrichtung eines Magnetfeldes, insbesondere des sehr schwachen Erdfeldes, anzuzeigen.

Erfindungsgemäß wird diese Aufgabe mit einem eingangs beschriebenen Verfahren gelöst, das durch die Merkmale des Anspruchs 1 gekennzeichnet ist. Bezüglich der Anordnung wird die Aufgabe mit den Merkmalen des Anspruchs 4 gelöst.

Dieses Verfahren hat den Vorteil, daß keine hochwertigen Filter erforderlich sind, weil nicht die Amplitudendifferenz der induzierten Spannung ausgewertet wird. An die Erregerwicklung der Magnetsonde wird eine rechteckförmige Wechselspannung gelegt. An der Meßwicklung der Magnetsonde wird die induzierte Spannung abgegriffen, die nur während der Ummagnetisierung des Eisenkerns ansteht. Die Dauer dieser induzierten Spannungsimpulse ist ein Maß für die Zeit, die die Sonde braucht, um vom positiven zum negativen Sättigungspunkt zu gelangen. Liegt kein äußeres Magnetfeld vor, so haben die positiven und negativen Spannungsimpulse die gleiche Länge, d. h. es werden Zeiten gleichen Betrags gemessen. Die Einwirkung eines äußeren Magnetfeldes verschiebt die Sättigungspunkte und damit die Zeitdauer der induzierten Spannungsimpulse. Die positiven und negativen Spannungsimpulse haben unterschiedliche Längen. Das eine Mal verlängert sich die Impulsdauer, das andere Mal verkürzt sie sich. Bildet man nun den Differenzbetrag aus der gemessenen Impulsdauer bei Vorhandensein eines äußeren Magnetfeldes und der Impulsdauer ohne äußeres Magnetfeld (Bezugswert), so ist dieser Betrag, der eine ermittelte Zeit darstellt, ein Maß für die äußere Feldstärke. Diese kann beispielsweise optisch angezeigt werden. Erfindungsgemäß wird der Differenzbetrag aus den positiven und negativen Spannungsimpulsen gebildet, so daß der Bezugswert, das ist die Zeit der Impulsdauer ohne äußeres Feld, eliminiert wird. Das hat den Vorteil, daß dieser Wert nicht eigens ermittelt werden muß. Das bedeutet, daß Nichtlinearitäten des Eisenkerns sowie Streuungen bei der Fertigung der Magnetsonden keinen Einfluß haben. Somit lassen sich Magnetsonden für dieses Meßverfahren preisgünstig und mit nicht allzu hohen Anforderungen an die Präzision fertigen. Ebenso läßt sich mit verhältnismäßig geringem Schaltungsaufwand die Feldstärke ermitteln.

In einer vorteilhaften Weiterbildung der Erfindung läßt sich dieses Verfahren für Magnetsonden, sogenannte Erdfeldsonden, anwenden, die zur Ermittlung der Richtung eines Magnetfeldes, z. B. des Erdfeldes, ausgebildet sind. Hierbei weist die Magnetsonde mindestens zwei in einem bestimmten Winkel zueinander stehende Schenkel mit mindestens jeweils einer Wicklung auf. Mit einer solchen Magnetsonde, die horizontal angeordnet ist, lassen sich die Feldstärken zweier senkrecht zueinander stehender Feldvektoren ermitteln. Aus den Feldstärken dieser zwei Feldkomponenten läßt sich, beispielsweise mittels eines Mikrocomputers, aufgrund trigonometrischer Beziehungen die Richtung der Feldlinien eines äußeren Magnetfeldes errechnen und anzeigen.

Besonders vorteilhaft ist es bei diesem Verfahren, an ein- und derselben Wicklung den Erregerstrom bzw. die Erregerspannung anzulegen und die induzierten Spannungsimpulse abzugreifen.

In einer Schaltungsanordnung zur Durchführung des Verfahrens zur Messung der Feldstärke ist zweckmäßigerweise eine Zeit-Meßeinrichtung vorgesehen. Diese mißt einmal die Impulsdauer der positiven induzierten Spannung, das andere Mal die Impulsdauer der negativen induzierten Spannung und bildet daraus den Differenzbetrag. Die rechteckförmige Wechselspannung wird durch periodisches Umpolen einer Gleichspannung erzeugt. Diese wird über einen Vorwiderstand an die Wicklung der Magnetsonde gelegt. Das periodische Umpolen wird von einer Steuervorrichtung vorgenommen, die auch die synchrone Anschaltung der induzierten positiven und negativen Spannungsimpulse an die Zeitmeßeinrichtung steuert. Der positive Spannungsimpuls wird an den ersten Eingang eines ersten logischen Verknüpfungsgliedes, der negative Spannungsimpuls an den ersten Eingang eines zweiten logischen Verknüpfungsgliedes geschaltet. Die zweiten Eingänge der logischen Verknüpfungsglieder sind von einem Taktgenerator beaufschlagt. Jedem logischen Verknüpfungsglied ist eine Zählvorrichtung, beispielsweise ein digitaler Zähler, nachgeschaltet, deren Ausgänge an einen Subtrahierer geleitet sind. Der dort gebildete Differenzbetrag wird als proportionale Größe der Feldstärke von einer nachgeordneten Anzeigevorrichtung angezeigt.

In einer weiteren Schaltungsanordnung wird vorteilhafterweise eine Magnetsonde benutzt, die erlaubt, die Feldstärke beider Komponenten eines Magnetfeldes, insbesondere des Erdfeldes, zu messen. Die Schaltungsanordnung ist ähnlich wie die vorgenannte Schaltungsanordnung aufgebaut, mit dem Unterschied, daß ein Teil der Schaltungselemente doppelt vorhanden ist. Die Magnetfeldsonde weist zwei Wicklungen auf, für jede Komponente des Magnetfeldes eine Wicklung. Denen sind entsprechend zwei Zeitmeßeinrichtungen nachgeordnet, die von der Steuervorrichtung entsprechend angeschaltet werden. Ebenso ist ein Taktgenerator vorgesehen, der gleichzeitig beide Zeitmeßeinrichtungen beaufschlagt. Ferner ist jeweils ein Ausgang der beiden Zeitmeßeinrichtungen mit einem Mikrocomputer verbunden. Aus den Feldstärken beider Feldkomponenten, die eine Funktion der ermittelten Zeiten darstellen, ermittelt der Mikrocomputer die Richtung der Feldlinien und zeigt diese Richtung mittels einer dem Mikrocomputer nachgeordneten Anzeigevorrichtung an. Die Anzeigevorrichtung kann so ausgestaltet sein, daß sie ähnlich wie ein Kompaß mit seiner Magnetnadel die Nordrichtung anzeigt. Ist beispielsweise eine solche Magnetsonde in einem ortsveränderlichen Fahrzeug angeordnet, so kann die Anzeigeeinrichtung so ausgestaltet sein, daß der Richtungswinkel des Fahrzeuges bezüglich der Nordrichtung angezeigt wird.

Anhand der Zeichnung sollen Ausführungsbeispiele sowie das Verfahren näher erläutert werden. Es zeigt

Fig. 1 die prinzipielle Anordnung einer Magnetsonde,

Fig. 2 die Hysteresekurve einer Magnetsonde mit entsprechend zugeordneten Strom- und Spannungskurven,

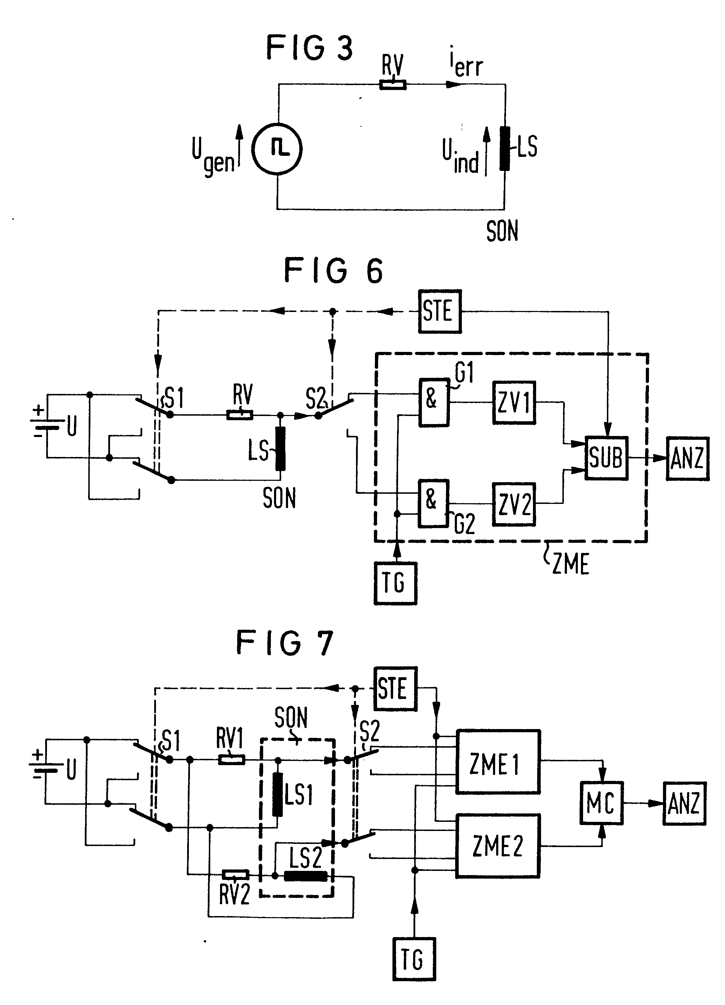

Fig. 3 ein Prinzipschaltbild einer Magnetsonde,

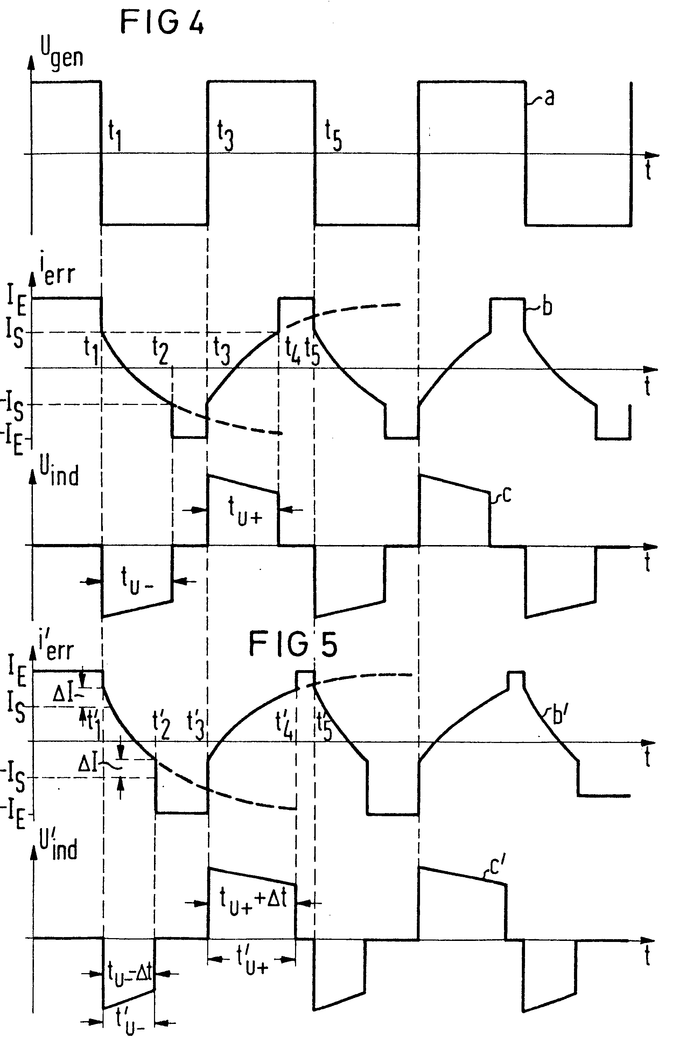

Fig. 4 den Strom-/Spannungsverlauf der Sondeninduktivität nach Fig. 3 ohne Einwirkung eines äußeren Magnetfeldes,

Fig. 5 den Strom-/Spannungsverlauf der Sondeninduktivität nach Fig. 3 mit Einwirkung eines äußeren Magnetfeldes,

Fig. 6 eine Schaltungsanordnung zur Ermittlung der Feldstärke,

Fig. 7 eine Schaltungsanordnung zur Ermittlung der Feldrichtung.

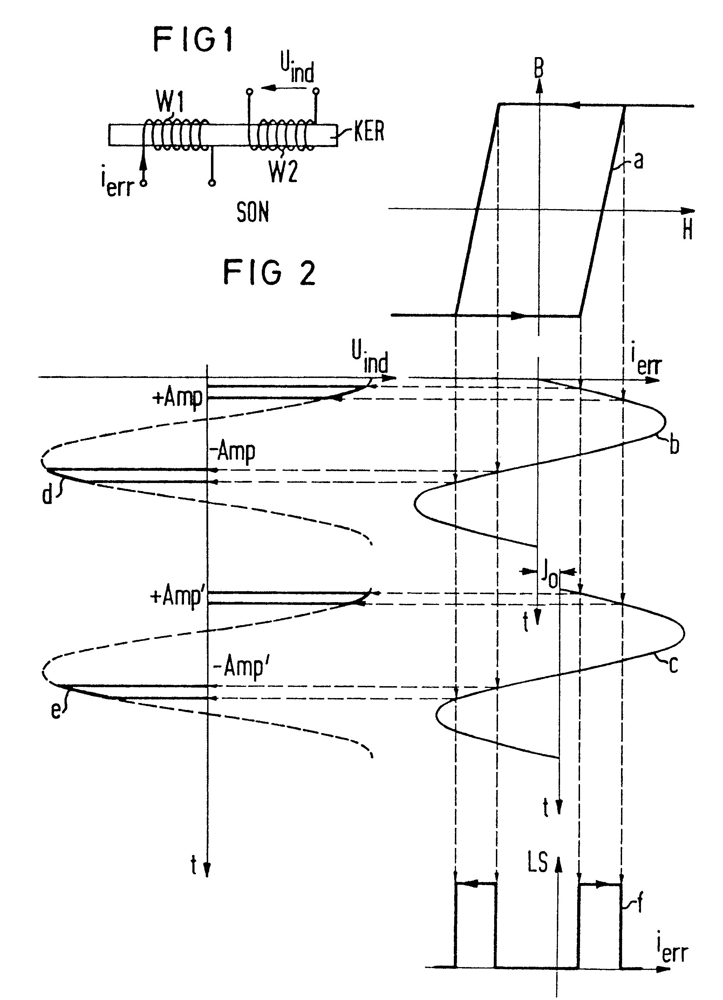

In Fig. 1 ist eine Magnetsonde SON dargestellt. Sie weist einen sättigbaren Eisenkern KER mit einer Primärwicklung W1 und einer Sekundärwicklung W2 auf. An die Wicklung W1 wird ein Erregerstrom $i_{err}$ angelegt, der ein inneres Magnetfeld erzeugt, so daß der Eisenkern abwechselnd den positiven und negativen Sättigungswert erreicht. In der Sekundärwicklung W2 wird dadurch eine Spannung $U_{ind}$ induziert.

In Fig. 2 ist die Hysteresekurve a einer Magnetsonde, entsprechend dazu mit Kurve b der Erregerstrom $i_{err}$ ohne äußeres Magnetfeld dargestellt. Die dazu entsprechend dargestellte Kurve d zeigt den Spannungsverlauf der induzierten Spannung $U_{ind}$.

Unter dem Einfluß eines äußeren Magnetfeldes verschiebt sich die Erregerstromkurve um den Betrag $J_o$, der proportional der Stärke des äußeren Magnetfeldes ist, so daß die Kurve c den Verlauf des Erregerstroms $i_{err}$ mit äußerem Magnetfeld darstellt. Entsprechend dazu ist der Spannungsverlauf der induzierten Spannung

$U_{ind}$ mit äußerem Magnetfeld in Kurve e dargestellt. Ist kein äußeres Magnetfeld vorhanden, so ist die positive und negative Amplitude +Amp und −Amp der induzierten Spannung $U_{ind}$ gleich groß (Kurve d). Überlagert sich diesem inneren Magnetfeld ein äußeres Feld, z. B. das Erdfeld, so wird je nach dessen Richtung und Stärke die Sättigung früher oder später eintreten, und damit wird die induzierte Sekundärspannung $U_{ind}$ unsymmetrisch (Kurve e). Das heißt, es ergeben sich unterschiedliche Amplituden für beide Halbwellen, +Amp' −Amp'. Dieser Unterschied ist ein Maß für die zu messende Feldstärke. Es ist ferner noch der Widerstandswert der Induktivität LS der Magnetsonde in Abhängigkeit des Erregerstroms $i_{err}$ mit Kurve f dargestellt.

In F i g. 3 ist das Prinzipschaltbild einer Magnetsonde SON dargestellt. Eine rechteckförmige Wechselspannung $U_{gen}$ liegt über den in Reihe geschalteten Vorwiderstand RV an der Sondeninduktivität LS, an der die induzierte Spannung $U_{ind}$ abgegriffen wird.

In F i g. 4 ist der zeitliche Verlauf der rechteckförmigen Wechselspannung $U_{gen}$ mit Kurve a, in zeitlicher Zuordnung dazu der Stromverlauf des Erregerstroms $i_{err}$ mit Kurve b und der Spannungsverlauf der induzierten Spannung $U_{ind}$ mit Kurve c ohne äußeres Magnetfeld dargestellt.

Hat die Magnetsonde SON ihren positiven Sättigungszustand erreicht, so fließt während der positiven Halbwelle der Spannung $U_{gen}$ ein positiver Endstrom $+J_E$. Wenn zum Zeitpunkt $t_1$ die Spannung $U_{gen}$ vom positiven zum negativen Wert wechselt, fällt der Erregerstrom von seinem Endwert $+J_E$ auf den positiven Wert des Sättigungsstroms $+J_S$ zurück. Während des Ummagnetisierens vergeht eine gewisse Zeit, so daß die Magnetsonde bis zum Zeitpunkt $t_2$ ihren negativen Sättigungspunkt $-J_S$ erreicht und dann auf den Wert des negativen Endstroms $-J_E$ springt und dort bis zum Zeitpunkt $t_3$ bleibt. Zu diesem Zeitpunkt wechselt die Erregerspannung von minus nach plus. Der Vorgang wiederholt sich in umgekehrter Richtung. Der Erregerstrom $i_{err}$ fällt vom $-J_E$ auf $-J_S$. Bis zum Zeitpunkt $t_4$ erreicht der Erregerstrom $i_{err}$ seinen positiven Sättigungspunkt $+J_S$ und springt dann, solange noch die positive Halbwelle der Spannung $U_{gen}$ ansteht, auf $+J_E$.

Liegt kein äußeres Magnetfeld vor, so haben die Sättigungspunkte $+J_S$ und $-J_S$ den gleichen Betrag. Die induzierte Spannung $U_{ind}$, die mit der Kurve c dargestellt ist, entsteht in dem Bereich, in dem die Sonde noch nicht in Sättigung ist. Das heißt, während des jeweiligen Ummagnetisierens steht ein induzierter Spannungsimpuls $U_{ind}$ an. Die Dauer $t_u$ des induzierten Spannungsimpulses $U_{ind}$ ist für den positiven und negativen Impuls gleich groß. Das ist die Zeitdauer vom Zeitpunkt $t_1$ bis $t_2$ für den positiven Spannungsimpuls und $t_3$ bis $t_4$ für den negativen Spannungsimpuls. Es ist also die Zeit für den positiven und den negativen Spannungsimpuls $t_{u+} = t_{u-} = t_u$.

In F i g. 5 ist der zeitliche Verlauf des Erregerstroms $i'_{err}$ mit Kurve b' und in entsprechend zeitlicher Zuordnung die induzierte Spannung $U'_{ind}$ (Kurve c') mit äußerem Magnetfeld dargestellt. Das äußere Magnetfeld bewirkt eine Änderung der Vormagnetisierung und somit eine Änderung der positiven und negativen Sättigungspunkte $+J_S$ und $-J_S$ um den Betrag $+\Delta J$. Dieser Betrag ist eine Funktion der Stärke des äußeren Magnetfeldes. Damit verschiebt sich der Sättigungspunkt für den positiven und negativen Erregerstrom $i_{err}$ um $+\Delta J$. Entsprechend ändert sich die Impulsdauer $t'_u$ der induzierten Spannung $U'_{ind}$.

Wie in Kurve c' dargestellt, ist die Impulsdauer $t'_u$ der induzierten Spannung $U'_{ind}$ für den negativen Spannungsimpuls um $\Delta t$ kürzer, also $t'_{u-} = t_u - \Delta t$ und für den positiven Spannungsimpuls um $\Delta t$ länger, also $t'_{u+} = t_u + \Delta t$.

Mißt man die beiden Zeiten $t'_u$ und $t'_{u+}$ und bildet die Differenz, so ergibt sich die Zeit: $t\Phi = 2\Delta t$, die eine Funktion der Sättigungspunktverschiebung $\Delta J$ ist und somit eine Funktion des äußeren Magnetfeldes.

Fig. 6 zeigt eine Schaltungsanordnung zur Ermittlung der Feldstärke mit einer Zeitmeßeinrichtung ZME. Die rechteckförmige Wechselspannung ist hier dargestellt durch das periodische Umpolen einer Gleichspannung U mittels des Schalters S1. Über den Vorwiderstand RV fließt der Erregerstrom $i_{err}$ in die Spulenwicklung LS der Magnetsonde SON. Das Antwortsignal, die induzierte Spannung $U_{ind}$ wird an der Wicklung LS abgegriffen und mittels des Schalters S2 abwechselnd an zwei Eingängen einer Zeitmeßeinrichtung ZME gegeben. Eine Steuervorrichtung STE steuert sowohl das periodische Umpolen der Gleichspannung U mit dem Schalter S1 als auch das dazu synchrone Umschalten des Schalters S2. Je nach Stellung des Schalters S2 gelangt das Antwortsignal einmal an einen ersten Eingang eines ersten UND-Gliedes G1 und zum anderen Mal an den ersten Eingang eines zweiten UND-Gliedes G2. Gleichzeitig sind beide UND-Glieder G1 und G2 mit Impulsen an zweiten Eingängen beaufschlagt, die von einem Taktgenerator TG erzeugt werden.

Der Ausgang der UND-Glieder G1 und G2 ist jeweils mit dem Eingang einer Zählvorrichtung ZV1 und ZV2 verbunden.

Diese Zählvorrichtung ZV können digitale Zähler sein. Der Ausgang der Zählvorrichtungen ZV1 und ZV2 ist jeweils an einen Eingang des Subtrahierers SUB geführt. Dieser wird von der Steuervorrichtung STE so angesteuert, daß er aus der gemessenen Impulsdauer $t'_u$ der positiven und der negativen Spannungsimpulse $U'_{ind}$ den Differenzbetrag bildet. Auf diese Weise wird der oben näher erwähnte Bezugswert $t_u$ eliminiert und nur die Zeit $t_\Phi = 2\Delta t$ ermittelt. Zur Erhöhung der Meßsicherheit und der Meßgenauigkeit kann der Subtrahierer SUB auch so gesteuert werden, daß er den Differenzbetrag aus mehreren positiven und negativen Spannungsimpulsen bildet. Diese so ermittelte Zeit $t_\Phi = 2\Delta t$ ist eine Funktion der Feldstärke des äußeren Magnetfeldes und kann in einer nachgeordneten Anzeigeein richtung ANZ angezeigt werden.

Fig. 7 zeigt eine Schaltungsanordnung zur Ermittlung der Richtung eines Magnetfeldes. Hierzu wird eine Magnetsonde SON verwendet, die erlaubt, beide Komponenten eines Magnetfeldes, d. h. die Feldvektoren, die senkrecht zueinander stehen, zu erfassen. Dazu weist die Sonde zwei Schenkel, die in einem bestimmten Winkel zueinander stehen, und jeweils eine Wicklung LS1 und LS2 auf. Die Ansteuerung dieser Schaltung erfolgt ähnlich wie in dem ersten Ausführungsbeispiel. Die Steuervorrichtung STE polt periodisch die Gleichspannung U mittels des Schalters S1 um und führt sie jeweils über einen Vorwiderstand RV1 an die Wicklung LS1 und parallel dazu über einen Vorwiderstand RV2 an die Wicklung LS2. Der von der Steuervorrichtung STE synchron dazu betätigte Schalter S2 greift jeweils die induzierte Spannung $U'_{ind}$ von den Wicklungen LS1 und LS2 der Magnetsonde SON ab und gibt sie jeweils alternierend auf zwei Zeitmeßeinrichtungen ZME1 und ZME2. Eine solche Zeitmeßeinrichtung ZME weist wie im vorherigen Ausführungsbeispiel zwei UND-Glieder G1 und G2 auf, denen nachgeordnet jeweils eine Zählvorrichtung ZV, beispielsweise Digitalzähler, und denen nachgeordnet einen Subtrahierer SUB auf.

Beide Zeitmeßeinrichtungen ZME1 und ZME2 sind von einem Taktgenerator TG mit Impulsen beaufschlagt. Ebenso steuert die Steuervorrichtung STE die Subtrahierer SUB, die in der Zeitmeßeinrichtung ZME1 die Differenz für $t_{\phi 1} = 2\,\Delta t_1$ der Wicklung LS1 und in der Zeitmeßeinrichtung ZME2 die Differenz für $t_{\phi 2} = 2\,\Delta t_2$ der Wicklung LS2 bilden. Diese so ermittelten zwei Zeitwerte sind eine Funktion der zu messenden Feldstärken beider zueinander senkrecht stehenden Feldkomponenten. Es ist jeweils ein Ausgang der Zeitmeßeinrichtungen ZME1 und ZME2 mit einem Mikrocomputer MC verbunden. Der Mikrocomputer MC ermittelt aufgrund trigonometrischer Beziehungen aus den Feldstärken beider Feldkomponenten die Richtung der Feldstärke des äußeren Magnetfeldes. Eine dem Mikrocomputer MC nachgeordnete Anzeigeeinrichtung ANZ zeigt die Feldrichtung an.

## Patentansprüche

1. Verfahren zur Bestimmung eines Magnetfeldes mittels einer Magnetsonde (SON), die einen sättigbaren Eisenkern und eine darauf angebrachte Wicklungsanordnung (LS) aufweist, bei dem an mindestens eine Wicklung der Wicklungsanordnung (LS) eine rechteckförmige Erregerwechselspannung gelegt wird, die im sättigbaren Eisenkern ein inneres Magnetfeld erzeugt, das sich mit einem äußeren Magnetfeld, z. B. dem Erdfeld, überlagert und die Sättigungsbedingungen des Eisenkerns verändert, und bei dem von mindestens einer Wicklung der Wicklungsanordnung (LS) ein Antwortsignal in Form von induzierten Spannungsimpulsen ($U'_{ind}$) abgeleitet wird, das eine Funktion der Stärke des äußeren Magnetfeldes ist, dadurch gekennzeichnet,

daß die Impulsdauer ($t'_u$) der einzelnen induzierten Spannungsimpulse ($U'_{ind}$) gemessen und mit einem Bezugswert ($t_u$) verglichen wird, wobei dieser Bezugswert ($t_u$) der Impulsdauer der induzierten Spannungsimpulse ($U_{ind}$) ohne Einwirken eines äußeren Magnetfeldes entspricht, daß der Differenzbetrag ($t\phi$) aus der gemessenen Impulsdauer ($t'_{u+}$; $t'_{u-}$) der positiven und der negativen Spannungsimpulse ($U'_{ind+}$; $U'_{ind-}$) gebildet wird, wobei der Bezugswert ($t_u$) eliminiert wird, und daß aus dem Differenzbetrag ($t\phi$) die Feldstärke ermittelt und angezeigt wird.

2. Verfahren nach Anspruch 1, dadurch gekennzeichnet, daß die Feldstärken zweier senkrecht in einer Ebene zueinander stehender Feldvektoren mittels einer Magnetsonde (SON), die mindestens zwei in einem bestimmten Winkel zueinander stehende, in einer Horizontalebene befindliche Schenkel mit jeweils mindestens einer Wicklung (LS1, LS2) aufweist, bestimmt werden, und daß aus diesen Feldstärken aufgrund trigonometrischer Beziehungen die Richtung der Feldlinien des äußeren Magnetfeldes ermittelt und angezeigt wird.

3. Verfahren nach Anspruch 1 oder 2, dadurch gekennzeichnet, daß an ein und derselben Wicklung (LS) der Magnetsonde (SON) der Erregerstrom ($i_{err}$) bzw. die Erregerspannung ($U_{gen}$) eingespeist und die induzierten Spannungsimpulse ($U'_{ind}$) abgenommen werden.

4. Schaltungsanordnung zur Durchführung des Verfahrens nach einem der Ansprüche 1 bis 3, mit einer Magnetsonde (SON), die einen sättigbaren Eisenkern und eine darauf angebrachte Wicklungsanordnung (LS) aufweist, mit einer Steuervorrichtung (STE), die zur Erzeugung der Erregerwechselspannung ($U_{gen}$) eine Gleichspannungsquelle (U) über einen steuerbaren ersten Umschalter (S1) periodisch umpolt und außerdem die Gleichspannungsquelle (U) mit einer Wicklung der Wicklungsanordnung (LS) verbindet, und mit einer Zeitmeßeinrichtung (ZME) zur Messung der Dauer der in einer Wicklung der Wicklungsanordnung (LS) induzierten Spannungsimpulse ($U'_{ind}$), dadurch gekennzeichnet, daß die Gleichspannungsquelle (U) über den steuerbaren (STE) ersten Umschalter (S1) und einen Vorwiderstand (RV) an die von der Erregerwechselspannung ($U_{gen}$) beaufschlagte Wicklung der Wicklungsanordnung (LS) gelegt ist, daß die induzierten Spannungsimpulse ($U'_{ind}$) der Magnetsonde (SON) über einen weiteren Umschalter (S2), der synchron zum ersten Umschalter (S1) von der Steuervorrichtung (STE) beaufschlagt ist, abwechselnd auf einen von zwei Eingängen der Zeitmeßeinrichtung (ZME) geführt sind, daß die Zeitmeßeinrichtung (ZME) zwei logische Verknüpfungsglieder (G1, G2), deren jeweiliger erster Eingang mit dem jeweiligen Eingang der Zeitmeßeinrichtung (ZME) verbunden ist und deren jeweiliger zweiter Eingang von einem Taktgenerator beaufschlagt ist, zwei den jeweiligen Verknüpfungsgliedern (G1, G2) nachgeschaltete Zählvorrichtungen (ZV1, ZV2) und einen den beiden Zählvorrichtungen (ZV1, ZV2) nachgeschalteten Subtrahierer (SUB) aufweist, wobei der Subtrahierer (SUB) von der Steuervorrichtung (STE) beaufschlagt ist und der Ausgang des Subtrahierers (SUB) auf eine der Zeitmeßeinrichtung (ZME) nachgeschaltete Anzeigeeinrichtung (ANZ) führt.

5. Schaltungsanordnung nach Anspruch 4, dadurch gekennzeichnet, daß die Magnetsonde (SON) mit mindestens zwei in einem bestimmten Winkel zueinander stehenden Schenkeln mit jeweils einer Wicklung vorgesehen ist, wobei die zweite Wicklung (LS2) mit einem weiteren Vorwiderstand (RV2) der ersten Wicklung (LS1) mit dem ersten Vorwiderstand (RV1) parallel geschaltet ist, daß zwei Zeitmeßeinrichtungen (ZME1, ZME2) vorgesehen sind, die jeweils vom Taktgenerator (TG) und der Steuervorrichtung (STE) beaufschlagt sind, wobei über den zweiten, steuerbaren Umschalter (S2) die induzierten Spannungsimpulse (U'$_{ind1}$) der ersten Wicklung (LS1) der ersten Zeitmeßeinrichtung (ZME1) und die induzierten Spannungsimpulse (U'$_{ind2}$) der zweiten Wicklung (LS2) der zweiten Zeitmeßeinrichtung (ZME2) zugeführt sind, und daß den beiden Zeitmeßeinrichtungen (ZME1, ZME2) ein Mikrocomputer (MC) nachgeschaltet ist, wobei der Ausgang des Mikrocomputers (MC) mit der Anzeigeeinrichtung (ANZ) verbunden ist.

## Claims

1. A method of determining a magnetic field by means of a magnetic probe (SON) which has a saturable iron core carrying a winding arrangement (LS), wherein at least one winding of the winding arrangement (LS) is connected to a rectangular, alternating excitation voltage which produces in the saturable iron core an internal magnetic field superimposed on an external magnetic field, e.g. the earth's field, and so changes the saturation conditions of the iron core, and wherein a response signal is derived from at least one winding of the winding arrangement (LS) consisting of induced voltage pulses (U'$_{ind}$), as a function of the magnitude of the external magnetic field, characterized in that the pulse duration (t'$_u$) of the individual induced voltage pulses (U'$_{ind}$) is measured and compared with a reference value (t$_u$) that corresponds to the pulse duration of the induced voltage pulses (U$_{ind}$) without the influence of an external magnetic field; that the difference (t$\tilde{\varnothing}$) between the measured pulse duration (t'$_{u+}$ ; t'$_{u-}$) of the positive and negative voltage pulses (U'$_{ind+}$ ; U'$_{ind-}$) is formed and the reference value (t$_u$) eliminated, and that from the difference (t$\tilde{\varnothing}$) the field strength is determined and displayed.

2. A method as claimed in claim 1, characterized in that the field strengths of two field vectors occurring at right angles to one another in one plane are determined by means of a magnetic probe (SON) having at least two flanks that form a specific angle to one another in a horizontal plane and are each provided with at least one winding (LS1, LS2), and that from these field strengths the direction of the field lines of the external magnetic field is determined, on the basis of trigonometrical relationships, and the result displayed.

3. A method as claimed in claim 1 or 2, characterized in that the excitation current (i$_{err}$) and the excitation voltage (U$_{gen}$) are input and the induced voltage pulses (U'$_{ind}$) are withdrawn across one and the same winding (LS) of the magnetic probe (SON).

4. A circuit arrangement for implementation of the method claimed in one of the claims 1 to 3, with a magnetic probe (SON) which has a saturable iron core carrying a winding arrangement (LS), a control device (STE) which periodically reverses the polarity of a d.c. voltage source (U) via a controllable, first change-over switch (S1) in order to produce the alternating excitation voltage (U$_{gen}$) and also connects the d.c. voltage source (U) to a winding of the winding arrangement (LS), and a time measuring device (ZME) to measure the duration of the voltage pulses (U'$_{ind}$) induced in a winding of the winding arrangement (LS), characterized in that the d.c. voltage source (U) is connected via a controllable (STE) first change-over switch (S1) and via a series resistor (RV) to that winding of the winding arrangement (LS) acted upon by the alternating excitation voltage (U$_{gen}$), that the induced voltage pulses (U'$_{ind}$) of the magnetic probe (SON) are fed alternately to one of two inputs of the time-measuring device (ZME) via a further change-over switch (S2) acted upon by the control device (STE) in synchronism with the first change-over switch (S1), that the time measuring device (ZME) has two logic-linking elements (G1, G2), each of which has its first input connected to the relevant input of the time measuring device (ZME) and its second input to a clock pulse generator, that said time measuring device has two counting devices (ZV1, ZV2) connected to the output end of the relevant logic-linking elements (G1, G2), and that said time measuring device has a subtractor (SUB) which is connected to the output end of the two counting devices (ZV1, ZV2), where the subtractor (SUB) is acted upon by the control device (STE) and the output of the subtractor (SUB) leads to a display device (ANZ) connected to the output end of the time measuring device (ZME).

5. A circuit arrangement as claimed in claim 4, characterized in that the magnetic probe (SON) is provided with at least two flanks which form a specific angle with one another and which each possess a winding, where the second winding (LS2) and a further series resistor (RV2) is connected in a path parallel to the first winding (LS1) by the first series resistor (RV1), that two time measuring devices (ZME1, ZME2) are provided, each of which is acted upon by the clock pulse generator (TG) and the control device (STE), where, via the second, controllable change-over switch (S2), the induced voltage pulses (U′$_{ind1}$) of the first winding (LS1) are fed to the first time measuring device (ZME1) and the induced voltage pulses (U′$_{ind2}$) of the second winding (LS2) are fed to the second time measuring device (ZME2), and that the two time measuring devices (ZME1, ZME2) are followed by a microcomputer (MC) whose output is connected to the display device (ANZ).

## Revendications

1. Procédé pour déterminer un champ magnétique à l'aide d'une sonde magnétique (SON), qui comporte un noyau de fer saturable et un ensemble d'enroulements (LS) monté sur ce noyau, et dans lequel à au moins un bobinage de l'ensemble d'enroulements (LS) est appliquée une tension alternative rectangulaire d'excitation qui produit, dans le noyau de fer saturable, un champ magnétique interne qui se superpose à un champ magnétique extérieur, par exemple le champ terrestre, et modifie les conditions de saturation du noyau de fer, et dans lequel on dérive à partir d'au moins un enroulement de l'ensemble d'enroulements (LS) un signal de réponse présent sous la forme d'impulsions de tension induites (U′$_{ind}$) et qui est une fonction de l'intensité du champ magnétique extérieur, caractérisé par le fait qu'on mesure la durée (t′$_u$) des différentes impulsions de tension induites (U′$_{ind}$) et qu'on la compare à une valeur de référence (t$_u$), cette valeur de référence (t$_u$) correspondant à la durée des impulsions de tension induites (U$_{ind}$) sans l'action d'un champ magnétique extérieur, qu'on forme la différence (t$\mathcal{P}$) entre les durées mesurées (t′$_{u+}$ ; t′$_{u-}$) des impulsions positives et négatives de tension (U′$_{ind+}$ ; U′$_{ind-}$), auquel cas la valeur de référence (t$_u$) est éliminée, et que l'on détermine et que l'on affiche l'intensité de champ à partir de la différence (t$\mathcal{P}$).

2. Procédé suivant la revendication 1, caractérisé par le fait qu'on détermine les intensités de champ de deux vecteurs champ perpendiculaires entre eux dans un plan au moyen d'une sonde magnétique (SON), qui comporte au moins deux branches situées dans un plan horizontal, faisant entre elle un angle déterminé et comportant respectivement un enroulement (LS1, LS2), et que la direction des lignes du champ magnétique extérieur est déterminée à partir de ces intensités de champ et sur la base de relations trigonométriques, et est affichée.

3. Procédé suivant la revendication 1 ou 2, caractérisé par le fait que le courant d'excitation (i$_{err}$) ou la tension d'excitation (U$_{gen}$) est appliqué à un même enroulement (LS) de la sonde magnétique (SON) et que les impulsions de tension induites (U′$_{ind}$) sont prélevées sur cet enroulement.

4. Montage pour la mise en oeuvre du procédé suivant l'une des revendications 1 à 3, comportant une sonde magnétique (SON) qui possède un noyau de fer saturable et un ensemble d'enroulements (LS) monté sur cette sonde, un dispositif de commande (STE), qui, pour la production de la tension alternative d'excitation (U$_{gen}$), inverse périodiquement la polarité d'une source de tension continue (U) par l'intermédiaire d'un premier commutateur (S1) pouvant être commandé, et relie en outre la source de tension continue (U) à un enroulement de l'ensemble d'enroulements (LS), et comportant un chronomètre (ZME) servant à mesurer la durée des impulsions de tension (U′$_{ind}$) induites dans un enroulement de l'ensemble d'enroulements (LS), caractérisé par le fait que la source de tension continue (U) est raccordée par l'intermédiaire du premier commutateur (S1) pouvant être commandé (STE) et d'une résistance additionnelle (RV) à l'enroulement de l'ensemble d'enroulements (LS), qui est chargé par la tension alternative d'excitation (U$_{gen}$), que les impulsions de la tension induite (U′$_{ind}$) de la sonde magnétique (SON) sont envoyées en alternance à l'une de deux entrées du chronomètre (ZME) par l'intermédiaire d'un autre commutateur (S2), qui est chargé en synchronisme avec le premier commutateur (S1) dans le dispositif de commande (STE), que le chronomètre (ZME) comporte deux circuits logiques (G1, G2), dont une première entrée respective est reliée à l'entrée respective du chronomètre (ZME) et dont la seconde entrée respective est chargée par un générateur de cadence, deux dispositifs de comptage (ZV1, ZV2) branchés en aval des circuits logiques (G1, G2), et un dispositif soustracteur (SUB), branché en aval des deux dispositifs de comptage (ZV1, ZV2), le dispositif soustracteur (SUB) étant chargé par le dispositif de commande (STE) et la sortie du dispositif soustracteur (SUB) aboutissant à un dispositif d'affichage (ANZ) branché en aval du chronomètre (ZME).

5. Montage suivant la revendication 4, caractérisé par le fait que la sonde magnétique (SON) est munie d'au moins deux branches faisant entre elles un angle déterminé et comportant chacune un bobinage, que le second enroulement (LS2) muni d'une autre résistance additionnelle (RV2) est branché en parallèle avec le premier enroulement (LS1) muni de la première résistance additionnelle (RV1), qu'il est prévu deux minuteries (ZME1, ZME2) qui sont chargées respectivement par le générateur de cadence (TG) et par le dispositif de commande (STE), auquel cas les impulsions de tension induites (U′$_{ind1}$) du premier enroulement (LS1) sont envoyées à la première minuterie (ZME1) et les impulsions de tension induites (U′$_{ind2}$) du second enroulement (LS2) sont envoyées à la seconde minuterie (ZME), par l'intermédiaire du second commutateur (S2) pouvant être commandé, et qu'en aval des deux minuteries (ZME1, ZME2) se trouve branché un micro-ordinateur (MC), dont la sortie est reliée au dispositif d'affichage (ANZ).

FIG 1

FIG 2

# FIG 3

# FIG 6

# FIG 7

FIG 4

FIG 5